## Europäisches Patentamt

## European Patent Office

## Office européen des brevets

(19)

(11) Veröffentlichungsnummer: **0 054 723**
**B1**

(12) **EUROPÄISCHE PATENTSCHRIFT**

(45) Veröffentlichungstag der Patentschrift:
06.02.85

(21) Anmeldenummer: 81109343.4

(22) Anmeldetag: 30.10.81

(51) Int. Cl.⁴: **H 03 H 9/25**

(54) **Akustischer Oberflächenwellenresonator.**

(30) Priorität: 22.12.80 US 218894

(43) Veröffentlichungstag der Anmeldung:
30.06.82 Patentblatt 82/26

(45) Bekanntmachung des Hinweises auf die Patenterteilung:
06.02.85 Patentblatt 85/6

(84) Benannte Vertragsstaaten:
**DE FR GB**

(56) Entgegenhaltungen:
**DE - A - 2 938 158**
**FR - A - 2 392 538**
**GB - A - 1 490 959**
**US - A - 3 886 504**

(73) Patentinhaber: **Hewlett-Packard Company,**
**3000 Hanover Street, Palo Alto California 94304 (US)**

(72) Erfinder: **Cross, Peter S., 882 Chimalus Drive, Palo Alto California 94087 (US)**
Erfinder: **Shreve, William R., 1444 Enderby Way, Sunnyvale California 94087 (US)**

(74) Vertreter: **Schulte, Knud, Dipl.-Ing., c/o Hewlett-Packard GmbH Europ. Patent- und Lizenzabteilung Postfach 1430 Herrenberger Strasse 130, D-7030 Böblingen (DE)**

**Beschreibung**

Die Erfindung betrifft einen akustischen Oberflächenwellenresonator mit einem Substrat mit piezoelektrischer Oberfläche, einer ersten und einer zweiten reflektierenden Gitterstruktur zum Aufrechterhalten von stehenden akustischen Oberflächenwellen auf der piezoelektrischen Oberfläche, sowie einer elektroakustischen Wandleranordnung auf der piezoelektrischen Oberfläche, die sich zwischen der ersten und der zweiten Gitterstruktur befindet.

In Oszillatorschaltungen ist normalerweise ein frequenzstabilisierendes Rückkopplungselement erforderlich. Ein solches Rückkopplungselement ist z.B. ein akustischer Oberflächenwellenresonator. Solche Oberflächenwellenresonatoren sind bekannt und im Schrifttum ausführlich beschrieben. Beispiele finden sich in den US-PSen 3886504 und 4144507. Dort ist ein akustischer Oberflächenwellenresonator beschrieben, der zwei mit Abstand voneinander angeordnete Gitterstrukturen auf einem piezoelektrischen Substrat sowie mindestens einen elektroakustischen Wandler aufweist, der zwischen den Gitterstrukturen angeordnet ist und entsprechend einem elektrischen Steuersignal auf dem piezoelektrischen Material akustische Oberflächenwellen anregt. Die gegenseitige Anordnung der Gitterstrukturen ist dabei so getroffen, dass sich aufgrund der Reflexionen eine vom elektroakustischen Wandler angeregte stehende akustische Oberflächenwelle ergibt. Das Resonanzverhalten des Oberflächenwellenresonators kann zur Frequenzstabilisierung einer Oszillatorschaltung benutzt werden.

Um bei einem Oszillator eine optimale Stabilisierung und ein möglichst hohes Signal-/Rauschverhältnis zu erreichen, ist es erforderlich, dass das frequenzstabilisierende Rückkopplungselement möglichst viel Leistung aufnehmen kann, wobei jedoch andere wünschenswerte Eigenschaften wie hoher Gütefaktor und geringer Einfügungsverlust erhalten bleiben sollen. Bei einem akustischen Oberflächenwellenresonator ist die Leistungsaufnahmemöglichkeit proportional zur akustischen Öffnung bzw. Breite des Bauelementes. Zur Stabilisierung von Oszillatoren sind daher akustische Oberflächenwellenresonatoren mit grosser akustischer Öffnung erwünscht. Deren Vergrösserung sind jedoch Grenzen gesetzt. Da der Oberflächenresonator im wesentlichen einen zweidimensionalen Wellenleiter darstellt, kann er eine Gruppe von sich als Querwellen bemerkbar machenden Schwingungsarten aufnehmen, deren Frequenzabstände umgekehrt proportional zum Quadrat der Öffnungsabmessungen sind. Dieses Phänomen ist beschrieben in «Journal of Applied Physics» 48 (12), Dezember 1977, Seiten 4955 bis 4961. Die Folge ist, dass bei grossen akustischen Öffnungen, die eine grosse Leistungsaufnahme ermöglichen, einige Querschwingungsarten auftreten, deren Frequenzen sehr nahe bei der Grundfrequenz liegen und eine erhebliche Verzerrung der Filtercharakteristik des Oberflächenwellenresonators verursachen. Diese Verzerrung kann sich z.B. in einem verminderten Gütefaktor des Resonators manifestieren. Auch kann sich das Phasenrauschen erhöhen, wenn der Resonator in einen Oszillator eingebaut ist. Die durch eine weite akustische Öffnung erzielten Vorteile werden dadurch zunichtegemacht. Aus diesen Gründen ist es in höchstem Masse erstrebenswert, diese Querschwingungsarten in einem akustischen Oberflächenwellenresonator zu unterdrücken, wenn dieser zur Stabilisierung eines Oszillators benutzt wird.

Zur Unterdrückung von Nebenschwingungsarten sind verschiedene Methoden bekannt geworden. Eine der am meisten bekannte ist die der sogenannten «Apodisation». Dabei ist die Konstruktion des elektroakustischen Wandlers auf die Grundschwingungsart der reflektierenden Gitterstruktur zugeschnitten, so dass keine Querschwingungsarten angeregt werden. Wenn jedoch die Frequenz eines solchen Oberflächenwellenresonators auf über etwa 500 MHz erhöht wird, ist die Unterdrückung von Querschwingungsarten mit dieser Methode nicht mehr einfach. Zwar lässt sich bei Einhaltung bestimmter Parameter ein Resonator konstruieren, bei dem Querschwingungen unterdrückt werden. Kleine Abweichungen in der Metallisierung des elektroakustischen Wandlers oder der Form der Gitterstruktur, wie sie üblicherweise bei der Fabrikation auftreten, lassen das Problem der Querschwingungen jedoch erneut zu Tage treten. Dementsprechend sind viele Fachleute der Meinung, dass es für akustische Oberflächenwellenresonatoren eine maximal mögliche akustische Öffnung gibt, wenn man Verzerrungen durch Querschwingungsarten vermeiden will, siehe z.B. Ultrasonics Symposium Proceedings, 1979 und 1980.

Eine weitere bekannte Methode zur Unterdrückung von Querschwingungsarten besteht in der Benutzung von Absorbern zum Dämpfen der Querschwingungen. Ein Absorber verschlechtert aber systembedingt den Gütefaktor des Resonators, da sowohl die erwünschte als auch die unerwünschte Schwingungsart durch den Absorber gehen müssen.

Die durch Querschwingungsarten hervorgerufenen Störfrequenzen werden durch die Breite des akustischen Oberflächenwellenresonators bestimmt. In einem schmalen Resonator sind die unerwünschten Querschwingungsarten in ihrer Frequenz weiter von der Hauptschwingungsart entfernt als bei einem breiten Resonator. Schmale Resonatoren haben aber nur eine niedrige Leistungsaufnahmefähigkeit.

Der vorliegenden Erfindung liegt die Aufgabe zugrunde, einen akustischen Oberflächenwellenresonator zu schaffen, der bei hoher Leistungsaufnahmefähigkeit keine Störeinflüsse durch Querschwingungsarten zeigt. Diese Aufgabe wird bei einem Oberflächenwellenresonator der eingangs genannten Art dadurch gelöst, dass eine Mehrzahl von parallelen Einzelresonatoren gemeinsam auf einer Seite des Substrates angeordnet ist, die je einen elektroakustischen Wandler der Wandleranordnung aufweisen, und dass die Wandler eine gemeinsame Zuleitung besitzen.

Erfindungsgemmäss werden also mehrere Oberflächenwellenresonatoren parallel betrieben. Die Einzelresonatoren können dabei so klein gehalten werden, dass Querschwingungsarten wirksam unterdrückt werden. Andererseits erlaubt die Parallelschaltung eine relativ hohe Leistungsaufnahme.

Diese Parallelschaltung von mehreren Einzelresonatoren wurde von der Fachwelt bisher nicht in Erwägung gezogen, da eine Reihe von Vorbehalten gegen sie bestand. So hielt man z.B. die Verdrahtung mehrerer parallelgeschalteter Resonatoren für zu kompliziert. Weitere Bedenken bestanden wegen eventueller Differenzen zwischen den Einzelresonatoren, die zu Störschwingungsarten führen können und damit den Gütefaktor herabsetzen und das Phasenrauschen des Oszillators erhöhen, ähnlich wie es aufgrund von Querschwingungsarten geschieht. Erfindungsgemäss wird dies jedoch dadurch vermieden, dass identische Einzelresonatoren auf einem gemeinsamen Substrat gebildet werden.

Weitere Bedenken gegen einen Parallelbetrieb von akustischen Oberflächenwellenresonatoren bestanden wegen der zusätzlichen Schwierigkeit beim Herstellen von Verbindungen zwischen den parallelen Strahlen, die die einzelnen Resonatoren enthalten. Bei der üblichen Konstruktion von Oberflächenwellenresonatoren werden die Verbindungen mit breiten Balken hergestellt, die in unmittelbarer Nähe der elektroakustischen Wandler aufgebracht werden. Bei einer parallelen Konfiguration müssen diese Balken die einzelnen Resonatoren kreuzen. Die Balken können dabei Nebenresonanzen und damit eine Verschlechterung der Filtercharakteristik des Resonators verursachen. Beim erfindungsgemässen Oberflächenwellenresonator treten diese Probleme nicht auf.

Weitere Bedenken betrafen zusätzliche Brechungsverluste bei parallel laufenden schmalen akustischen Strahlen. Solche Verluste existieren zwar, es hat sich aber herausgestellt, dass sie sich nicht verschlimmern, wenn Einzelresonatoren parallelgeschaltet werden, zumal der erfindungsgemässe Oberflächenwellenresonator üblicherweise bei Frequenzen betrieben wird, bei denen andere Verluste überwiegen.

In der oben erwähnten US-PS 3886504 wird beiläufig ein Parallelbetrieb von einzelnen akustischen Oberflächenwellenresonatoren vorgeschlagen. Dabei geht es jedoch offensichtlich darum, eine gewünschte Gesamt-Frequenzcharakteristik zu erzielen, die mit der eines Mehrpol-Bandpassfilters vergleichbar ist. Es finden sich keine Hinweise auf die praktische Ausführung einer solchen Parallelschaltung, noch auf die Minimierung von Querschwingungsarten unter Benutzung einer solchen Parallelschaltung.

Die Erfindung wird im folgenden anhand von Ausführungsbeispielen in Verbindung mit der zugehörigen Zeichnung erläutert. In der Zeichnung zeigen

Figur 1 schematisch einen akustischen Oberflächenwellenresonator gemäss einer ersten Ausführungsform der Erfindung;

Figur 2 eine abgewandelte Ausführungsform der Erfindung mit einem Resonator in Vielfachstruktur mit vier je einen Eingang aufweisenden und parallelgeschalteten Unterelementen; und

Figur 3 eine weitere Ausführungsform der Erfindung mit einem Resonator in Vielfachstruktur mit vier je zwei Eingänge aufweisenden und parallelgeschalteten Unterelementen.

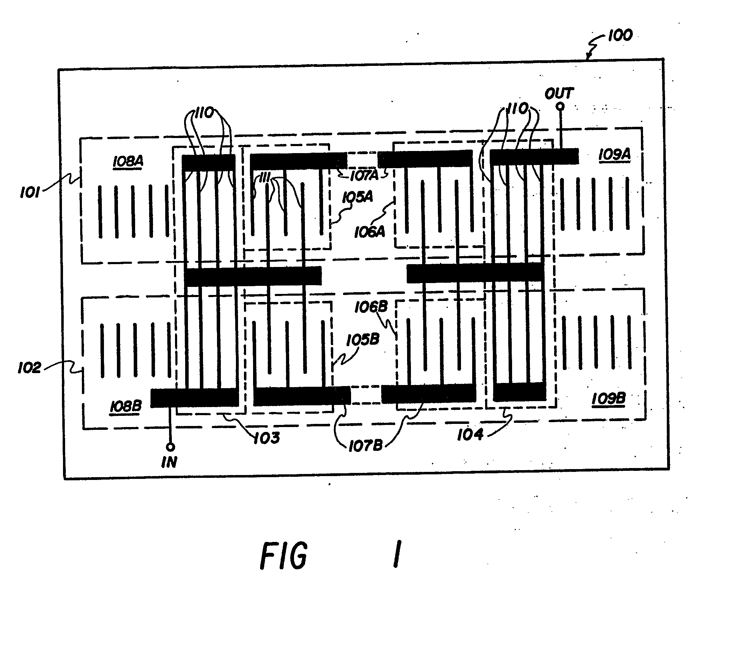

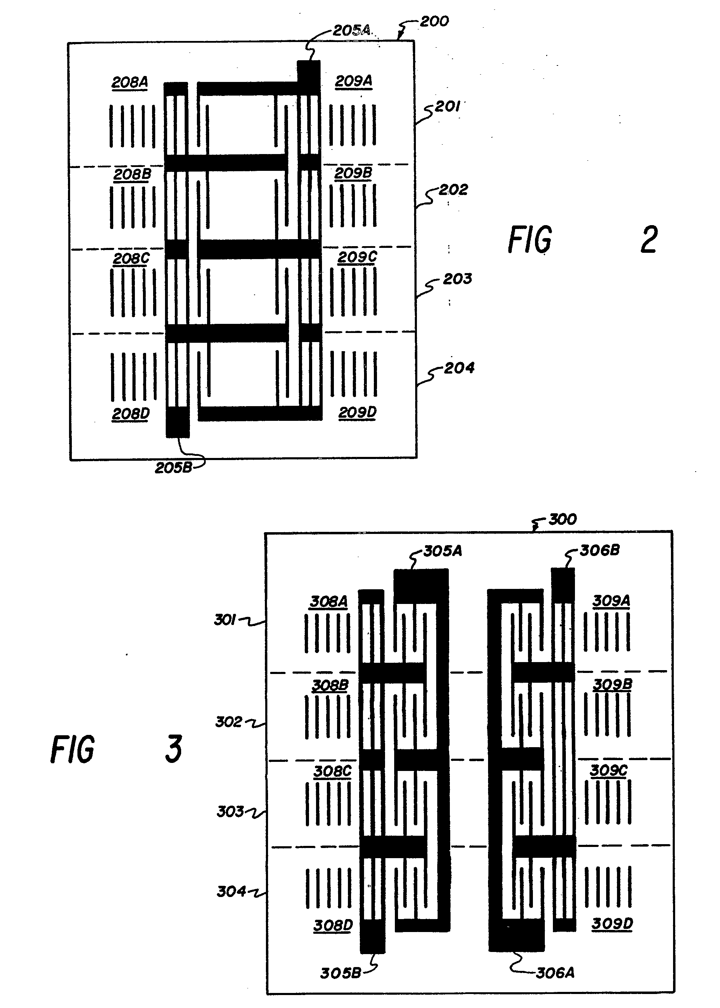

In Figur 1 ist ein akustischer Oberflächenwellenresonator 100 dargestellt, der zwei Einzelresonatoren 101 und 102 aufweist. Die Anzahl von zwei Einzelresonatoren ist nicht zwingend, es können auch mehr sein. Dieser Fall ist z.B. in Figuren 2 und 3 dargestellt, wo je vier parallele Einzelresonatoren vorhanden sind.

Jeder Einzelresonator 101 bzw. 102 weist zwei Gitter 108 und 109 mit einem elektroakustischen Eingangswandler 105 und einem elektroakustischen Ausgangswandler 106 sowie zugeordneten elektrischen Verbindungen 103 und 104 auf, die zwischen den Gittern angeordnet sind. Der Buchstabe A weist in Figur 1 auf die Zugehörigkeit zum Einzelresonator 101 hin, während der Buchstabe B auf die Zugehörigkeit zum Einzelresonator 102 hinweist. Die elektrischen Verbindungen 103 und 104 können massive Metallstreifen sein, was jedoch zu Verzerrungen der Frequenzcharakteristik führen kann. Durch Benutzung anderer Metallisierungskonfigurationen oder stepgartig befestigten Drähten können elektrische Verbindungen geschaffen werden, die den Betrieb des Vielfachstruktur-Oberflächenwellenresonators nicht beeinflussen. Bei der Ausführungsform gemäss Figur 1 müssen diese Verbindungen zwischen Gitter 108 und Wandler 105 sowie zwischen Gitter 109 und Wandler 106 angeordnet sein. Das Wesentliche dieser Konstruktion besteht darin, dass die Einzelresonatoren 101 und 102 schmal genug sind, dass durch Querschwingungsarten hervorgerufene Störfrequenzen weit entfernt von der Resonanzfrequenz des Oberflächenwellenresonators 100 liegen.

Die gemeinsamen Verbindungsleiter 103 und 104 sorgen für eine elektrische Verbindung zu den elektroakustischen Eingangswandlern 105A und 105B sowie den elektroakustischen Ausgangswandlern 106A und 106B. Die Wandler 105A, 105B, 106A und 106B weisen im vorliegenden Beispiel fingerartig ineinandergreifende Elektroden 111 auf. Die Masseanschlüsse dieser Wandler sind durch Leiterbalken 107A und 107B verbunden.

Beim bevorzugten Ausführungsbeipiel gehen die gemeinsamen Anschlüsse 103 und 104 zu parallelen Elektroden 110, die sich in periodischen Abständen zwischen den Gitterstrukturen 108 und 109 erstrecken. Auf diese Weise ist nur eine geringe Unterbrecherwirkung zwischen den Wandlern 105 und 106 und den Gitterstrukturen 108 und 109 vorhanden. Ein breiter massiver Anschluss würde die Periodizität der Gitterstrukturen unterbrechen und könnte Störresonanzen zwischen Gitter und Wandler hervorrufen.

Wird der Oberflächenwellenresonator 100 in eine Schaltung eingefügt, werden in diese nur die interessierenden Frequenzen in der Nähe der Resonanzfrequenz eingekoppelt. Daher werden alle von Störschwingungen herrührenden nachteiligen Effekte auf einem vernachlässigbaren Niveau gehalten, da solche Störfrequenzen von der Resonanzfrequenz weit entfernt sind. Aus diesem Grunde ist auch die Frequenzcharakteristik des Oberflächenwellenresonators 100 nach Phase oder Amplitude im wesentlichen unverzerrt.

Figuren 2 und 3 zeigen Vielfachstruktur-Oberflächenwellenresonatoren mit je jeweils vier parallelgeschalteten Einzelresonatoren. In Figur 2 ist ein Resonator 200 dargestellt, der vier Einzelresonatoren 201 bis 204 mit nur einem Eingang aufweist. Der Resonator 200 besitzt einen einzelnen elektroakustischen Wandler 205, der zwischen Gitterstrukturen 208A bis D einerseits und 209A bis D andererseits angeordnet ist. Elektrische Anschlüsse 205A und 205B zum Wandler 205 bestehen aus einer Vielzahl von Elektroden, die sich periodisch zwischen den Gitterstrukturen 208 und 209 erstrecken.

Figur 3 zeigt einen Oberflächenwellenresonator 300 mit zwei Eingängen und vier parallelgeschalteten Einzelresonatoren 301 bis 304. Beim Resonator 300 sind zwei elektroakustische Wandler 305 und 306 zwischen Gitterstrukturen 308 (A – D) und 309 (A – D) angeordnet. Elektrische Verbindungen 305B und 306B zu den Wandlern 305 bzw. 306 bestehen aus einer Vielzahl von Elektroden, die sich periodisch zwischen den Gitterstrukturen 308 und 309 erstrecken. Die verbleibenden elektrischen Anschlüsse 305A und 306A sind zwischen den Wandlern angeordnete breite Streifen.

**Patentansprüche**

1. Akustischer Oberflächenwellenresonator mit einem Substrat mit piezoelektrischer Oberfläche, einer ersten und einer zweiten reflektierenden Gitterstruktur zum Aufrechterhalten von stehenden akustischen Oberflächenwellen auf der piezoelektrischen Oberfläche sowie einer elektroakustischen Wandleranordnung auf der piezoelektrischen Oberfläche, die sich zwischen der ersten und der zweiten Gitterstruktur befindet, dadurch gekennzeichnet, dass eine Mehrzahl von parallelen Einzelresonatoren (101, 102) gemeinsam auf einer Seite des Substrates angeordnet ist, und dass die Wandleranordnung (105) eine Mehrzahl von einzelnen elektroakustischen Wandlern (105A, 105B) mit gemeinsamer Zuleitung (103) enthält, die jeweils einem Einzelresonator (101, 102) zugeordnet sind.

2. Oberflächenwellenresonator nach Anspruch 1, dadurch gekennzeichnet, dass eine zweite elektroakustische Wandleranordnung (106) auf der piezoelektrischen Oberfläche vorgesehen ist und aus der stehenden akustischen Oberflächenwelle ein elektrisches Ausgangssignal ableitet, wobei die zweite Wandleranordnung (106) ebenfalls eine Mehrzahl von einzelnen elektroakustischen Wandlern (106A, 106B) enthält, die jeweils einem Einzelresonator (101, 102) zugeordnet sind und eine zweite gemeinsame Zuleitung (104) haben.

3. Oberflächenwellenresonator nach Anspruch 1, dadurch gekennzeichnet, dass die gemeinsame Zuleitung (103) eine Vielzahl von parallelen Elektroden (110) aufweist, die sich periodisch zwischen der ersten (108) und der zweiten (109) Gitterstruktur erstrecken.

4. Oberflächenwellenresonator nach den Ansprüchen 2 und 3, dadurch gekennzeichnet, dass die zweite gemeinsame Zuleitung (104) eine Vielzahl von parallelen Elektroden (110) aufweist, die sich periodisch zwischen der ersten (108) und der zweiten (109) Gitterstruktur erstrecken.

5. Oberflächenwellenresonator nach Anspruch 1, dadurch gekennzeichnet, dass die erste gemeinsame Zuleitung (103) ein steppartig angehefteter Draht ist.

6. Oberflächenwellenresonator nach den Ansprüchen 2 und 5, dadurch gekennzeichnet, dass die zweite gemeinsame Zuleitung (104) ein steppartig angehefteter Draht ist.

**Claims**

1. A surface acoustic wave resonator with a substrate having a piezoelectric surface, a first and a second reflecting grating structure for maintaining standing surface acoustic waves on the piezoelectric surface, and further an electroacoustic transducer assembly on the piezoelectric surface, which is located between the first and the second grating structure, characterized in that a plurality of parallel individual resonators (101, 102) is arranged in common on one side of the substrate, and in that the transducer assembly (105) comprises a plurality of individual electroacoustic transducers (105A, 105B) with a common connector (103), which are respectively assigned to an individual resonator (101, 102).

2. A surface wave resonator as in claim 1, characterized in that a second elektroacoustic transducer assembly (106) is provided on the piezoelectric surface for deriving an electrical output signal from the standing surface acoustic wave, the second transducer assembly (106) also comprising a plurality of individual electroacoustic transducers (106A, 106B), which are respectively assigned to an individual resonator (101, 102) and have a second common connector (104).

3. A surface wave resonator as in claim 1, characterized in that the common connector (103) comprises a plurality of parallel electrodes (110) which extend periodically between the first (108) and the second (109) grating structure.

4. A surface wave resonator as in claims 2 and 3, characterized in that the second common connector (104) comprises a plurality of parallel electrodes (110) which extend periodically between the first (108) and the second (109) grating structure.

5. A surface wave resonator as in claim 1, characterized in that the first common connector (103) is a stitch-bonded wire.

6. A surface wave resonator as in claims 2 and 5, characterized in that the second common connector (104) is a stitch-bonded wire.

## Revendications

1. Résonateur à ondes acoustiques de surface avec un substrat à surface piézoélectrique, une première et une seconde structure réfléchissante de grille pour le maintien d'ondes acoustiques stationnaires de surface sur la surface piézoélectrique, ainsi qu'un dispositif transducteur électroacoustique sur la surface piézoélectrique, qui se trouve entre la première et la seconde structure de grille, caractérisé en ce qu'une pluralité de résonateurs individuels (101, 102) en parallèle est disposée collectivement sur une face du substrat, et en ce que le dispositif transducteur (105) comporte une pluralité de transducteurs électroacoustiques individuels (105A, 105B) avec ligne commune d'amenée (103), qui sont affectés respectivement à un résonateur individuel (101, 102).

2. Résonateur à ondes de surface selon la revendication 1, caractérisé en ce qu'un second dispositif transducteur électroacoustique (106) est prévu sur la surface piézoélectrique et, de l'onde acoustique stationnaire de surface, dérive un signal électrique de sortie, le second dispositif transducteur (106) contenant également une pluralité de transducteurs électroacoustiques individuels (106A, 106B) auxquels sont affectés respectivement un résonateur individuel (101, 102) et qui ont une seconde ligne commune d'amenée (104)

3. Résonateur à ondes de surface selon la revendication 1, caractérisé en ce que la ligne commune d'amenée (103) présente une multiplicité d'électrodes parallèles (110), qui s'étendent avec périodicité entre la première (108) et la seconde (109) des structures de grille.

4. Résonateur à ondes de surface selon les revendications 2 et 3, caractérisé en ce que la seconde ligne commune d'amenée (104) présente une multiplicité d'électrodes parallèles (110), qui s'étendent avec périodicité entre la première (108) et la seconde (109) des structures de grille.

5. Résonateur à ondes de surface selon la revendication 1, caractérisé en ce que la première ligne commune d'amenée (103) est un fil fixé par piquage.

6. Résonateur à ondes de surface selon les revendications 2 et 5, caractérisé en ce que la seconde ligne commune d'amenée (104) est un fil fixé par piquage.

FIG 1

205A

200

208A

209A

201

208B

209B

202

FIG      2

208C

209C

203

204

208D

209D

205B

300

305A

306B

308A

309A

301

308B

309B

302

FIG      3

308C

309C

303

304

308D

309D

305B

306A